# EUROPÄISCHE PATENTANMELDUNG

(11) **EP 2 093 549 A2**
(43) Veröffentlichungstag der Anmeldung: **26.08.2009**
(21) Anmeldenummer: 09401002.2
(22) Anmeldetag: 19.02.2009
(51) Int. Cl.: G01K 7/20

(54) **Messverfahren, insbesondere für Widerstands-Temperaturfühler**

(30) Priorität: 21.02.2008 DE 102008002777
(71) Anmelder: EAB Elektro Anlagen Bau GmbH, 21683 Stade-Bützlieth (DE)
(72) Erfinder: Viertmann, Peter, 21717 Deinste (DE)
(74) Vertreter: Hansen, Jochen

(57) **Zusammenfassung**

Die Erfindung betrifft ein Messverfahren zur Bestimmung eines variablen Messwiderstands, insbesondere an einem Widerstands-Temperaturfühler, bei dem ein Messstrom über ein Zuleitungspaar mit zwei Leitern, den Messwiderstand und ein Ausgangsleitungspaar mit zwei Leitern geführt wird, wobei daraus resultierende Messwerte um Leitungswiderstände der jeweiligen Leitungspaare laufend korrigiert werden, bei Ausfall/Kontaktproblemen an einem der vier Leiter das diesem Leiter zugeordnete Leitungspaar überbrückt wird und die folgenden Messwerte mit ermittelten Leitungswiderständen korrigiert werden.

Ferner betrifft die Erfindung eine Messanordnung mit einem variablen Messwiderstand (1), insbesondere einem Widerstands-Temperaturfühler, der einen Eingang (11) und einen Ausgang (12) hat, wobei an dem Eingang (11) ein Zuleitungspaar (21) aus zwei Leitern (23, 24) und an dem Ausgang (12) ein Ausgangsleitungspaar (22) aus zwei Leitern (25, 26) angeschlossen sind, und mit einer Auswerteeinheit (3), an die die vier Leiter (23, 24, 25, 26) des Zuleitungspaares (21) und des Ausgangsleitungspaares (22) angeschlossen sind, wobei je Leitungspaar (21, 22) ein schaltbarer Kontakt (41, 42) vorgesehen ist, der bei Ausfall/Kontakproblemen an einem Leiter dieses Leitungspaares die beiden Leiter des Leitungspaares kontaktiert

## Beschreibung

Die Erfindung betrifft ein Messverfahren zur Bestimmung eines variablen Messwiderstands, insbesondere an einem Widerstands-Temperaturfühler, bei dem ein Messstrom über ein Zuleitungspaar mit zwei Leitern, den Messwiderstand und ein Ausgangsleitungspaar mit zwei Leitern geführt wird, wobei daraus resultierende Messwerte um Leitungswiderstände der jeweiligen Leitungspaare laufend korrigiert werden.

Derartige Messverfahren und -anordnungen sind im Stand der Technik als sog. Vierleiterschaltungen zur Bestimmung eines variablen Messwiderstands, insbesondere für Widerstands-Temperaturfühler, bekannt. Dabei dient die Vierleiterschaltung einer präzisen Messung des variablen Messwiderstands mit Ausblendung der Anschlusswiderstände, die insbesondere durch die Zuleitungen bzw. Ausgangsleitungen gebildet werden.

Zur Temperaturmessung wird die elektrische Widerstandsänderung eines temperaturabhängig leitenden Materials, beispielsweise Platin, verwendet. Die Platin-Temperatursensoren werden durch ihren Nennwiderstand R₀ bei einer Temperatur von 0 °C charakterisiert und entsprechend Pt100 (R₀ = 100 Ω), Pt200 (R₀ = 200 Ω), Pt500 (R₀ = 500 Ω) bzw. Pt1000 (R₀ = 1 k Ω) bezeichnet. Dabei weist ein Pt100 Widerstandssensor bei 0 °C einen elektrischen Widerstand von 100 Ω auf. Bei steigender Temperatur erhöht sich der Widerstand um 0,385 Ω pro 1 °C; entsprechend sinkt der Widerstand bei sinkender Temperatur. Das temperaturempfindliche Element kann von einem Platindraht oder auch von einer im Dünnschichtverfahren aufgebrachten Platinschicht gebildet werden. Die mechanisch empfindlichen Sensoren werden meist in einem Glas- oder Keramikkörper eingebettet.

Bei Widerstandstemperaturfühlern mit Vierleiterschaltung sind an den beiden Kontaktenden des Platindrahts bzw. der Platinschicht, also am Eingang und Ausgang je ein Leitungspaar angeschlossen. Somit kann bei der Vierleiterschaltung jeweils ein Messstrom über das Zuleitungspaar und auch das Ausgangsleitungspaar geleitet werden, um den Leitungswiderstand, also den Anschlusswiderstand real ermitteln zu können. Ferner können die Leitungspaare für die Messung des Spannungsabfalls, also dem einer bestimmten Temperatur entsprechenden elektrischen Widerstand am Widerstands-Temperaturfühler verwendet werden. Dazu sind die vier Leiter an eine Auswerteeinheit, beispielsweise eine speicherprogrammierbare Schaltung (SPS) mit analoger Eingangskarte angeschlossen.

Werden von der Auswerteeinheit Ausfall oder Kontaktprobleme an einem (oder auch mehreren) der vier Leiter festgestellt, ist die Messung unbrauchbar und muss wiederholt werden. Da eine kontinuierliche Temperaturerfassung für viele technische Prozesse als Produktionsparameter äußerst wichtig ist, bedeutet dies häufig den Ausfall des gesamten Produktionsprozesses. Beispielsweise muss bei der Herstellung von Kohlenfaserverbundwerkstoffen eine kontinuierliche Temperaturerfassung an den ortsveränderlichen Betriebsmitteln, insbesondere den Backformen bzw. an den entsprechenden Bauteilen gewährleistet werden. Fällt die Temperaturmessung aufgrund von Verbindungsfehlern, nämlich Ausfall oder Kontaktproblemen aus, darf das in dieser Backform hergestellte Bauteil nicht oder nur nach einer zeit- und kostenaufwendigen Nachkontrolle verwendet werden. Da jedoch Verbindungsfehler in Form von Kontaktproblemen und dergleichen an den ortsveränderlichen Betriebsmitteln, die nur über Steckverbindungen und entsprechenden vieradrigen Verbindungskabeln mit der Auswerteeinheit verbunden sein können, nicht verhindert werden können, treten diese Ausfälle relativ häufig auf, was zu erheblichen Produktionsausfällen führt.

Aus der DE 102 58 366 A1 ist ein Verfahren und eine Vorrichtung zur Widerstandsmessung eines temperaturabhängigen Widerstandselements bekannt. Bei einem Verfahren zur Widerstandsmessung eines temperaturabhängigen Widerstandselements, bei dem im Normalbetrieb der Widerstand in Vierleitertechnik mit einem Strom- und einem separaten Messpfad gemessen wird, erfolgt bei Leitungsbruch in den Anschlussleitungen automatisch eine Umschaltung auf Dreileitertechnik bzw. Zweileitertechnik.

Weiter ist aus der DE 44 28 689 A1 ein Verfahren und eine Anordnung zum Betreiben einer an einen Multiplexer angeschlossenen Vierleiterschaltung für Widerstandsthermometer mit einer Messwiderstandsgröße bekannt. Hierbei ist es möglich sowohl eine Vierleitermessung als auch eine Dreileitermessung mit einem nahezu gleichen Schaltungsaufwand zu ermöglichen.

Aufgabe der Erfindung ist es daher, ein Messverfahren für die eingangs beschriebene Schaltung anzugeben, mit dem die Temperaturmessung auch bei Ausfall/Kontaktproblemen an den vier Leitern möglichst fortgeführt werden kann.

Gelöst wird diese Aufgabe mit einem Messverfahren gemäß Anspruch 1.

Wenn bei Ausfall/Kontaktproblemen an einem der vier Leiter, das diesem Leiter zugeordnete Leitungspaar überbrückt wird und die folgenden Messwerte mit ermittelten Leitungswiderständen korrigiert werden, wird die Messung mit zuvor ermittelten Leitungswiderständen fortgeführt. Eine Abschaltung des momentan ablaufenden Prozesses ist somit nicht erforderlich, da die Temperatur weiterhin aufgezeichnet wird. Allerdings verlieren die Temperaturwerte während der Überbrückung an Präzision, da der aktuelle Leistungswiderstand nicht mehr ermittelt werden kann. Hierzu werden die ermittelten Leitungswiderstände aus der Messauswertung während des laufenden Messverfahrens abgeleitet. Mit dieser Ausführungsform können Änderungen des Leitungswiderstandes während des Messverfahrens bei der Weiterberechnung der Messwertkorrektur im Fall eines Leiterausfalls berücksichtigt werden. Bevorzugt wird dabei dem noch kontaktierten Leiter des von Ausfall/Kontaktproblemen betroffenen Leitungspaares der diesem zugeordnete, ermittelte Leitungswiderstand für die weitere Korrektur zugrundegelegt.

Dadurch, dass für den korrigierten Messwert ein Toleranzbereich vorgewählt wird und bei Überschreitung des Toleranzbereiches das Messverfahren mit einer Fehlermeldung abgebrochen wird, können falsche Messwertkorrekturen ermittelt werden. In diesem Falle muss das Messverfahren abgebrochen werden.

Um eine Rückkehr in das präzisere Messverfahren nach der Vierleiterschaltung bei Wiederherstellung der Kontaktierung auch während eines Messverfahrens zu ermöglichen, wird in ständiger Wiederholung die Kontaktierung der vier Leiter überprüft und bei Feststellung der Kontaktwiederkehr die Überbrückung des/der Leitungspaare geöffnet.

Wenn die ermittelten Leitungswiderstände vor Durchführung des eigentlichen Messverfahrens bestimmt werden, können die für den Notfall erforderlichen Leitungswiderstände in einer Vorprüfung vor Beginn des eigentlichen Messverfahrens ermittelt und in der Auswerteeinheit abgespeichert werden.

Vorrichtungsgemäß kann die Messfortführung dadurch erreicht werden, dass je Leitungspaar ein schaltbarer Kontakt vorgesehen ist, der bei Ausfall/Kontaktproblemen an einem Leiter dieses Leitungspaares die beiden Leiter des Leitungspaares kontaktiert. Bevorzugt werden beide Leitungspaare parallel überbrückt. Vorrichtungsgemäß realisiert werden kann dies dadurch, dass für die schaltbaren Kontakte ein Relais mit zwei Arbeitskontakten vorgesehen ist, die bei Aktivierung des Relais geschlossen sind. Entsprechend kann je Leitungspaar ein Leiter ausfallen, ohne dass die Messung abgebrochen werden muss.

Hierzu kann das aus vier Leitern bestehende Messkabel wenigstens eine Steckverbindung aufweisen, wobei die schaltbaren Kontakte zwischen der Auswerteeinheit und der wenigstens einen Steckverbindung angeschlossen sind. Hierdurch wird sichergestellt, dass die besonders störanfälligen Steckverbindungen alle auf der Messstrecke zwischen schaltbaren Kontakten und dem variablen Messwiderstand liegen. Damit wird bei einer Kontaktierung der schaltbaren Kontakte eine mögliche Fehlerquelle an irgendeiner der Steckverbindungen in jedem Fall überbrückt.

Nachfolgend wird ein bevorzugtes Ausführungsbeispiel der Erfindung anhand der beiliegenden Zeichnungen detailliert beschrieben.

### Darin zeigt:

- Fig. 1: eine Messanordnung zur Ausführung des erfindungsgemäßen Messverfahrens und
- Fig. 2: ein Ablaufdiagramm der in der Auswerteeinheit realisierten Routine.

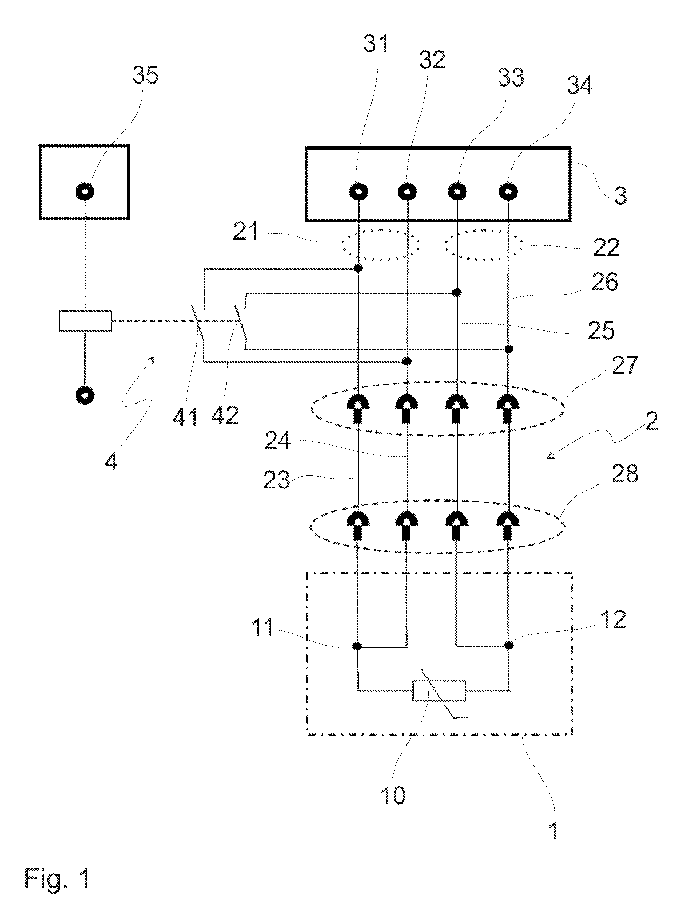

In Fig. 1 ist schematisch eine Schaltung der Messanordnung zur Ausführung des erfindungsgemäßen Messverfahrens dargestellt. Ein Widerstands-Temperaturfühler 1 ist an einem Betriebsmittel, beispielsweise Backform, zur Überwachung eines Produktionsprozesses angeordnet. Der Widerstands-Temperaturfühler 1 besitzt einen Platindraht 10, der einen Nennwiderstand R₀ von 100 Ω hat. Dieser sog. Pt100-Sensor weist einen Eingang 11 und einen Ausgang 12 auf, an denen vier Leiter 23, 24, 25, 26 , die in einem Verbindungskabel 2 zusammengefasst sind, angeschlossen sind. Dabei bilden zwei Leiter 23, 24 ein Zuleitungspaar 21, das gemeinsam am Eingang 21 des Widerstands-Temperaturfühlers 1 angeschlossen ist. Die weiteren beiden Leiter 25, 26 bilden ein Ausgangsleitungspaar 22, wobei beide Leiter 25, 26 am Ausgang 12 des Widerstands-Temperaturfühlers 1 angeschlossen sind.

In dem Verbindungskabel 2 sind Steckverbindungen, im dargestellten Ausführungsbeispiel zwei vierpolige Steckverbindungen 27, 28 vorgesehen, um das jeweilige Betriebsmittel mit dem Widerstands-Temperaturfühler 1 ortsveränderlich und variabel verbinden zu können. Für jeden Messaufbau wird dann über lose verlegte Verbindungskabel 2 mittels der Steckverbindungen 27, 28 eine Verbindung zwischen Widerstands-Temperaturfühler 1 und Auswerteeinheit 3 erstellt.

Das Verbindungskabel 2 mit seinen beiden Leitungspaaren 21 und 22, also den vier Leitern 23, 24, 25, 26 ist an eine Auswerteeinheit 3, beispielsweise eine speicherprogrammierbare Steuerung (SPS) mit analoger Eingangskarte für Pt100-Sensoren für die Vierleiterschaltung angeschlossen. In der Auswerteeinheit 3 wird einerseits ein Messstrom zur Ermittlung des Leitungswiderstandes einmal über das Zuleitungspaar 21 und ein anderes Mal über das Ausgangsleitungspaar 22 geführt. Entsprechend werden dabei die Leitungswiderstände der Leiter 23, 24 bzw. 25, 26 ermittelt. Ferner wird in der Auswerteeinheit 3 ein Messstrom über den Widerstands-Temperaturfühler 1, also den Platindraht 10 geleitet. Dabei wird der Spannungsabfall gemessen und die zuvor gemessenen Leitungswiderstände bei der Auswertung des Messwertes berücksichtigt. Entsprechend ergibt sich ein korrigierter Messwert, der die Anschlusswiderstände vollständig kompensiert. Mithin können mit dieser Schaltung Temperaturmessungen hoher Genauigkeit erzielt werden.

Zwischen den Anschlusskontakten 31, 32, 33, 34 der Auswerteeinheit 3 und der Steckverbindung 27 sind sowohl für das Zuleitungspaar 21 wie auch für das Ausgangsleitungspaar 22 Überbrückungsleitungen vorgesehen, die über jeweils einen schaltbaren Kontakt 41, 42 geführt sind. Die schaltbaren Kontakte 41, 42 gehören zu einem Relais 4, das in Arbeitsstellung aktiviert die schaltbaren Kontakte 41 und 42 parallel schließt. Entsprechend sind bei aktiviertem Relais 4 der Leiter 23 mit dem Leiter 24 des Zuleitungspaares 21 und der Leiter 25 mit dem Leiter 26 des Ausgangsleitungspaares 22 kontaktiert. Das Relais 4 ist über einen Ausgang 35 an der Auswerteeinheit 3 von dieser Auswerteeinheit 3 aktivierbar angeschlossen. In der Auswerteeinheit 3 ist eine entsprechende Auswertung und Ansteuerung des Relais 4 über den Ausgang 35 der Auswerteeinheit 3 programmiert.

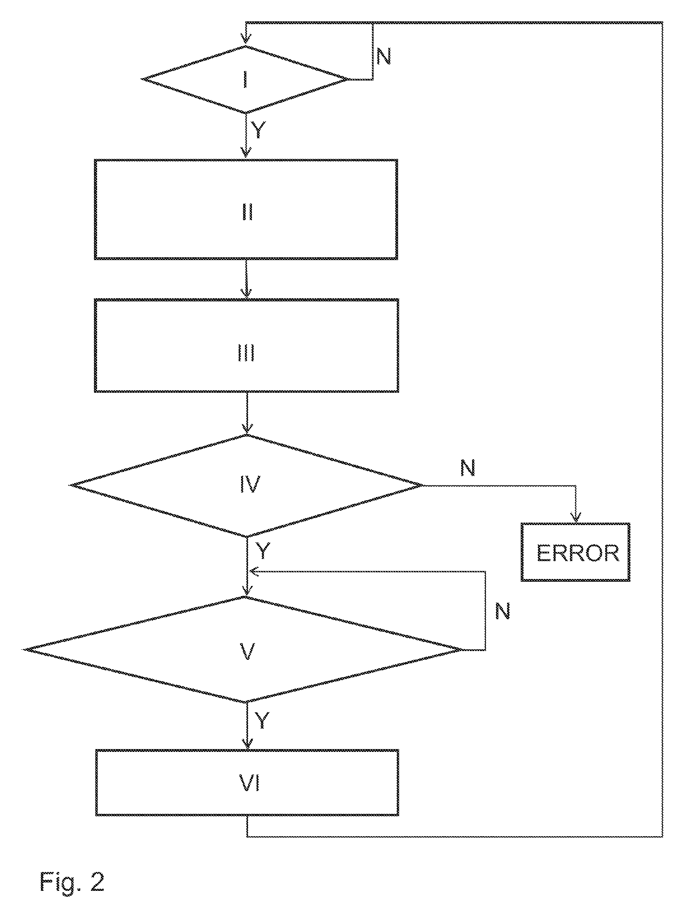

Fig. 2 zeigt ein Ablaufdiagramm des in der Auswerteeinheit 3 realisierten Programms. In dem Programm wird im ersten Schritt I abgefragt, ob ein Ausfall bzw. Kontaktprobleme an einem oder mehreren der vier Leiter vorliegt. Diese erste Abfrage wird in einer Schleife ständig wiederholt.

Liegt eine Störung vor, wird in einem zweiten Schritt II der letzte korrekte Messwert (Temperatur-Messwert) weitergeschrieben und das Relais 4 gesetzt, so dass die Arbeitskontakte 41 und 42 geschlossen sind und somit quasi eine Zweileitermessung über den Widerstands-Temperatursensor 1 realisiert ist. Gleichzeitig wird eine Meldung "Zweileitermessung" ausgegeben. Diese Störung wird im Meldearchiv festgehalten, damit anschließend nach Beendigung des Produktionszyklusses der Fehler nötigenfalls behoben werden kann.

Vor Beginn des eigentlichen Messverfahrens während der Produktion wird der Leitungswiderstand über die für den nun folgenden Produktionszyklus und das dabei parallel laufende Messverfahren erforderlichen Aufbau der Verbindungskabel 2, insbesondere mit seinen kritischen Steckverbindungen 27, 28 gemessen und in der Auswerteeinheit 3 als ermittelter Leitungswiderstand abgespeichert.

Dieser ermittelte Leitungswiderstand wird bei der Berechnung des nun im Zweileitermessverfahren ermittelten Messwertes in einem dritten Schritt III berücksichtigt, so dass sich daraus ein korrigierter Messwert ergibt, der für den Produktionsablauf weitergeschrieben wird.

Im vierten Programmschritt IV wird geprüft, ob der Messwert innerhalb eines Toleranzbereiches liegt und somit als zuverlässig gilt. Sollte dies nicht der Fall sein, wird die Messung mit einer Störungsmeldung (ERROR) abgebrochen, so dass der Produktionszyklus gestört ist.

Liegt der Wert innerhalb des Toleranzbereiches, wird in einem fünften Schritt V periodisch geprüft, ob der betroffene Leiter wieder Kontakt hat. Sollte dies der Fall sein, erfolgt eine Rückschaltung des Messverfahren auf die Vierleiterschaltung in einem sechsten Schritt VI, in dem das Relais 4 über Ausgang 35 der Auswerteeinheit 3 in Ruhestellung rückfällt, also sich die Arbeitskontakte 41, 42 öffnen. Die weitere Aufzeichnung der Temperatur-Messwerte erfolgt dann in der bekannten Vierleiterschaltung mit präziser Berücksichtigung des aktuell gemessenen Leitungswiderstandes.

Vorteilhaft wird damit mit dem erfindungsgemäßen Messverfahren eine Möglichkeit geschaffen, auch bei Kontaktproblemen, die insbesondere an den Steckverbindungen 27, 28 bei ortsveränderlichen Messanordnungen entstehen, einen Totalausfall der Temperaturmessung zu verhindern. Die dabei etwas weniger genaue Messung der Temperatur ist vernachlässigbar und kann ggf. nach Durchführung der Messung durch nachträgliche Angleichung des Leitungswiderstandes vor der Messung und nach der Messung geringfügig korrigiert werden. In der Regel bleiben die Abweichungen der gemessenen Temperatur im Laufe eines Messzykluses deutlich unterhalb der für die jeweilige Produktion vorgegebenen Temperaturtoleranzen. Somit stellt dieses Messverfahren eine erhebliche Verbesserung der Gesamtproduktivität bei temperaturüberwachten Prozessen dar.

### Bezugszeichenliste

- 1: variabler Messwiderstand, Widerstands-Temperaturfühler
- 10: Platindraht
- 11: Eingang
- 12: Ausgang

- 2: Verbindungskabel
- 21: Zuleitungspaar
- 22: Ausgangsleitungspaar
- 23: Leiter
- 24: Leiter
- 25: Leiter
- 26: Leiter
- 27: Steckverbindung
- 28: Steckverbindung

- 3: Auswerteeinheit
- 31: Anschlusskontakt
- 32: Anschlusskontakt
- 33: Anschlusskontakt
- 34: Anschlusskontakt
- 35: Ausgang Relais

- 4: Relais
- 41: schaltbarer Kontakt, Arbeitskontakt
- 42: schaltbarer Kontakt, Arbeitskontakt

## Patentansprüche

1. Messverfahren zur Bestimmung eines variablen Messwiderstands, insbesondere an einem Widerstands-Temperaturfühler, bei dem ein Messstrom über ein Zuleitungspaar mit zwei Leitern, den Messwiderstand und ein Ausgangsleitungspaar mit zwei Leitern geführt wird, wobei daraus resultierende Messwerte um Leitungswiderstände der jeweiligen Leitungspaare laufend korrigiert werden, wobei bei Ausfall/Kontaktproblemen an einem der vier Leiter, das diesem Leiter zugeordnete Leitungspaar überbrückt wird, **dadurch gekennzeichnet, dass** die folgenden Messwerte mit ermittelten Leitungswiderständen korrigiert werden, wobei die ermittelten Leitungswiderstände aus der Messauswertung während des laufenden Messverfahrens abgeleitet werden und dem noch kontaktierten Leiter des von Ausfall/Kontaktproblemen betroffenen Leitungspaares der diesem zugeordnete, ermittelte Leitungswiderstand für die weitere Korrektur zugrundegelegt wird.

2. Messverfahren nach Anspruch 1, **dadurch gekennzeichnet, dass** für den korrigierten Messwert ein Toleranzbereich vorgewählt wird und bei Überschreitung des Toleranzbereiches das Messverfahren mit einer Fehlermeldung abgebrochen wird.

3. Messverfahren nach Anspruch 1 oder 2, **dadurch gekennzeichnet, dass** in ständiger Wiederholung die Kontaktierung der vier Leiter überprüft wird und bei Feststellung der Kontaktwiederkehr die Überbrückung des/der Leitungspaare geöffnet wird.

4. Messverfahren nach Anspruch 1, 2 oder 3, **dadurch gekennzeichnet, dass** beide Leitungspaare parallel überbrückt werden.
